# EUROPÄISCHE PATENTSCHRIFT

(11) **EP 1 600 781 B1**
(45) Veröffentlichungstag und Bekanntmachung des Hinweises auf die Patenterteilung: **02.09.2015**
(21) Anmeldenummer: 04031004.7
(22) Anmeldetag: 30.12.2004
(51) Int. Cl.: G01R 1/073, G01R 1/04, H01L 21/68

(54) **Prüfeinrichtung zur elektrischen Prüfung eines Prüflings**
Device for the electrical test of a device under test
Dispositif pour le test électrique d'un dispositif à tester

(30) Priorität: 28.05.2004 DE 102004027887
(43) Veröffentlichungstag der Anmeldung: 30.11.2005
(73) Patentinhaber: Feinmetall GmbH, 71083 Herrenberg (DE)
(72) Erfinder: Böhm, Gunther, 71154 Nufringen (DE)
(74) Vertreter: Grosse, Rainer

(56) Entgegenhaltungen:
- EP-A1- 0 918 371
- WO-A-01/09623
- WO-A-2004/001807
- DE-A1- 2 905 175
- DE-A1- 10 125 345
- US-A1- 2002 024 354
- US-A1- 2002 109 514
- US-A1- 2002 191 406
- US-B1- 6 483 328
- US-B1- 6 509 751
- PATENT ABSTRACTS OF JAPAN Bd. 1996, Nr. 03, 29. März 1996 (1996-03-29) -& JP 07 294580 A (SHARP CORP), 10. November 1995 (1995-11-10)

## Beschreibung

Die Erfindung betrifft eine Prüfeinrichtung zur elektrischen Prüfung eines Prüflings, insbesondere zur Prüfung von Wafern, gemäß dem Oberbegriff des Anspruchs 1.

Elektrische Prüfeinrichtung der eingangs genannten Art dienen dazu, einen Prüfling elektrisch zu kontaktieren, um seine Funktionsfähigkeit zu testen. Die elektrische Prüfeinrichtung stellt elektrische Verbindungen zum Prüfling her, d.h., sie kontaktiert einerseits elektrische Anschlüsse des Prüflings und stellt andererseits elektrische Kontakte zur Verfügung, die mit einem Prüfsystem verbunden werden, das über die Prüfeinrichtung dem Prüfling elektrische Signale zuführt, um für eine Funktionsprüfung beispielsweise Widerstandsmessungen, Strom- und Spannungsmessungen und so weiter durchzuführen. Da es sich bei dem elektrischen Prüfling oftmals um sehr kleine elektronische Bauelemente handelt, beispielsweise um elektronische Schaltungen auf einem Wafer, aus dem elektronische Bauelemente gefertigt werden, besitzen die stiftförmigen Kontaktelemente des Kontaktkopfs extrem kleine Abmessungen. Um nun eine Anschlussmöglichkeit zum erwähnten Prüfsystem zu schaffen, stehen die Kontaktelemente des Prüfkopfs in Berührungskontakt mit einer Anschlussvorrichtung, die eine Umsetzung auf einen größeren Kontaktabstand vornimmt und insofern das Anschließen von elektrischen Verbindungskabeln ermöglicht, die zum Prüfsystem führen. Bei der Prüfung befindet sich der Prüfling in der Prüfebene und die Prüfeinrichtung wird axial, vorzugsweise in vertikaler Richtung, auf den Prüfling abgesenkt, so dass die einen Enden der stiftförmigen Kontaktelemente den Prüfling kontaktieren und die anderen Enden der stiftförmigen Kontaktelemente gegen die Kontaktflächen der Anschlussvorrichtung treten. Die Abstützvorrichtung bringt -in axialer Richtung- die Andrückkraft auf, mit der der Prüfling beaufschlagt wird, um die erwähnten Kontaktierungen herbeizuführen. Gleichzeitig wird durch die Abstützung der oftmals flächig ausgebildeten Anschlussvorrichtung an der Abstützvorrichtung einem Durchbiegen der Anschlussvorrichtung aufgrund von Reaktionskräften durch die Kontaktierung des Prüflings entgegengewirkt. Dennoch ist aufgrund von Fertigungstoleranzen und äußeren Bedingungen nicht sichergestellt, dass die Kontaktstifte der Kontaktstiftanordnung mit etwa gleichem Anpressdruck den Prüfling kontaktieren. Schon eine geringe Abweichung von der Planarität eines Bauteils, kann dazu führen, dass ein bestimmter Anteil der Kontaktstifte frühzeitig beim Absenken den Prüfling kontaktiert und bei der Prüfung auch mit stärkerem Kontaktdruck als andere Kontaktstifte an den Prüfling angepresst werden. Schlimmstenfalls kann es bei der bekannten Prüfeinrichtung vorkommen, dass bestimmte Kontaktstifte keinen Kontakt zum Prüfling erhalten, obwohl andere Kontaktstifte mit gewünschtem Kontaktdruck gegen den Prüfling anliegen. Geringfügige Abweichungen gleichen die Kontaktstifte von sich aus aus, da sie bevorzugt als Knickdrähte ausgebildet sind, die beim Kontaktieren in Längsrichtung beaufschlagt werden und hierdurch leicht bogenförmig elastisch durchaufschlagt werden und hierdurch leicht bogenförmig durch-biegen. Dieser Ausgleich ist jedoch nicht immer ausreichend.

Aus der US-2002/0024354A ist eine Prüfeinrichtung bekannt, bei der einzelne Elemente der Prüfeinrichtung verkippt werden können. Al-ternativ sieht diese Literaturstelle eine Ausbildung einer Prüfeinrichtung vor, bei der Teile der Prüfeinrichtung entsprechend einer Formgebung des Prüflings verformt werden.

Der Erfindung liegt die Aufgabe zugrunde, eine elektrische Prüfeinrichtung der eingangs genannten Art zu schaffen, die stets eine sichere Kontaktierung des Prüflings gewährleistet.

Diese Aufgabe wird erfindungsgemäß durch die Merkmale des Anspruchs 1 gelöst. Durch Einstellung der Zugmittel und/oder Druckmittel wirkt die Abstützvorrichtung derart auf die Anschlussvorrichtung, dass letztere sich so vorzugsweise elastisch verformt, dass die verteilt angeordneten Kontaktflächen entsprechend weit in axialer Richtung der Prüfeinrichtung, vorzugsweise in vertikaler Richtung, verlagert werden und auf diese Art und Weise beispielsweise die Planarität der Anordnung der Kontaktflächen erzielt werden kann. Dies ist dann geboten, wenn der Prüfling einwandfrei planar ausgebildet ist und auch ansonsten keine Bauteile der Prüfeinrichtung durch Fertigungstoferanzen oder äußere Einflüsse Abweichungen aufweist, sondern lediglich die Anschlussvorrichtung keine einwandfreie Planarität aufweist, die dann jedoch erfindungsgemäß hergestellt wird. Nach einem anderen Anwendungsfall kann jedoch auch vorgesehen sein, dass beispielsweise der als Wafer ausgebildete Prüfling keine einwandfreie Planarität aufweist und es demzufolge zu unterschiedlichen Kontaktierungsdrücken bei den Kontaktelementen, bis hin zu Fehlkontakten kommt. Mittels der entsprechend einzustellenden Zugmittel und/oder Druckmittel lässt sich Abhilfe schaffen, indem die Anordnung der Kontaktflächen der Anschlussvorrichtung derart hinsichtlich der Ebenheit oder einer bewusst gewünschten Nichtebenheit eingestellt wird, um den erwähnten Abweichungen entgegenzuwirken. Die Zugmittel und/oder Druckmittel gestatten es ferner, eine Anpassung an die jeweilige Kontaktierungsaufgabe vorzunehmen, die erforderlich ist, wenn die Prüfeinrichtung mit unterschiedlich großen Kontaktierungskräften arbeiten muss. Liegen beispielsweise Prüflinge mit nur wenigen Prüfpunkten vor, so werden nur wenige Kontaktstifte benötigt und es ist nur eine dementsprechend geringe Kontaktkraft für die Prüfung aufzubringen. Besitzt ein Prüfling sehr viele Kontaktpunkte, so dass sehr viele Kontaktstifte zum Einsatz kommen, so muss eine wesentlich größere Kontaktkraft aufgebracht werden, damit pro Stift die gleiche Kontaktierungs-Einzelkraft wirkt. Dementsprechend stärker wird die Anschlussvorrichtung belastet und kann daher eher aufgrund von Reaktionskräften verformt werden, was wiederum zu einer Verlagerung entsprechender Kontaktflächen führt. Durch die erwähnten Zugmittel und/oder Druckmittel lässt sich eine Voreinstellung der Planarität oder Nichtplanarität der Anschlussvorrichtung bewirken, die insbesonderte -wie erwähnt- flächig ausgebildet ist, beispielsweise von einer Leiterplatte gebildet wird.

Ferner ist vorgesehen, dass die Zugmittel und/oder Druckmittel Temperaturausdehnungen der Anschlussvorrichtung in einer Ebene zulassen, die parallel zur Prüfebene verläuft. Da bei der Prüfung unterschiedliche Raumtemperaturen vorliegen können und/oder vorzugsweise die Prüfung auch bei unterschiedlichen Prüflingstemperaturen durchgeführt wird, um die Funktion des Prüflings auch innerhalb eines bestimmten Temperaturbereichs prüfen zu können, treten thermisch bedingte Längenänderungen der einzelnen Bauelemente, insbesondere in Ebenen parallel zur Prüfebene auf. Diese Längenänderungen sind unvermeidbar und werden dann von den Zug- und/oder Druckmitteln nicht behindert, wenn diese innerhalb der erwähnten Ebenen Änderungen zulassen. Dies ist dadurch gegeben, dass die Zugmittel und/oder Druckmittel als Pendelzugmittel und/oder Pendeldruckmittel ausgestaltet sind. In Längserstreckung der Zugmittel und/oder Druckmittel besteht mechanische Starrheit, um die erwünschten Zugkräfte und/oder Druckkräfte aufzubringen, quer zu dieser Längserstreckung ist jedoch eine entsprechende Verlagerung durch Pendelung möglich, wodurch die erwähnten Längenausdehnungen nicht behindert werden. Hierbei ist anzumerken, dass Prüfungen von Wafern beispielsweise im Temperaturbereich von - 40°C bis + 150°C durchgeführt werden.

Nach einer Weiterbildung der Erfindung ist vorgesehen, dass mehrere Zugmittel und/oder Druckmittel verteilt, bevorzugt matrixartig verteilt, im zentralen Bereich der Prüfeinrichtung, insbesondere im Grundflächenbereich der Kontaktstiftanordnung, vorgesehen sind. Dieser zentrale Bereich dient der Aufnahme der Kontaktstifte und stellt damit den Prüfbereich dar. Befinden sich die Zugmittel und/oder Druckmittel in diesem Bereich, so lässt sich dieser entsprechend axial ausrichten beziehungsweise deformieren, um die gewünschte Planarität oder Nichtplanarität herzustellen.

Es ist vorteilhaft, wenn die Zugmittel und/oder Druckmittel Gewindestifte aufweisen, die zur Aufbringung von Zugkräften und/oder Druckkräften mit Stellmuttern zusammenwirken. Eine Verstellung einer Stellmutter auf dem zugehörigen Gewindestift führt in der einen Drehrichtung der Stellmutter zum Aufbringen von Druckkräften und in der anderen Drehrichtung der Stellmutter zum Erzeugen von Zugkräften. Hierbei ist die Größe der Druckkräfte und die Größe der Zugkräfte ferner durch entsprechend weites Verdrehen der Stellmutter variierbar, so dass eine individuelle, stufenlose Einstellung möglich ist.

Ferner ist es vorteilhaft, wenn die einen Enden der Gewindestifte an der Anschlussvorrichtung befestigt sind und sich die Stellmuttern an der Abstützvorrichtung abstützen. Die Stellmuttern bleiben dann von außen her zugänglich und können bei der Kalibrierung der Prüfeinrichtung entsprechend einfach verstellt werden.

Insbesondere sind die der Anschlussvorrichtung zugeordneten Enden der Gewindestifte mit Köpfen versehen, die von an der Anschlussvorrichtung befestigten Haltesockeln aufgenommen sind. Die Aufnahme der Köpfe in den Haltesockeln erfolgt pendelnd, so dass die auftretenden Temperaturlängenänderungen nicht behindert werden.

Die Gewindestifte liegen vorzugsweise in Durchgangsöffnungen der Abstützvorrichtung ein oder durchragen diese Durchgangsöffnungen. Dabei sind die Durchgangsöffnungen bevorzugt als Stufenbohrungen mit jeweils einem Bohrungsabschnitt mit kleinerem und einem Bohrungsabschnitt mit größerem Durchmesser ausgebildet, wobei in den Bohrungsabschnitten mit größerem Durchmesser, die an der Außenseite der Abstützvorrichtung liegen, die Stellmuttern einliegen und sich einerseits an den Stufen der Stufenbohrungen und andererseits an Verschlussstücken in den im Durchmesser größeren Bohrungsabschnitten abstützen. Hierdurch ist es durch ein Verdrehen der Stellmuttern möglich, von der Abstützvorrichtung ausgehende Druckkräfte oder Zugkräfte mittels der einzelnen Gewindestiftanordnungen auf die Anschlussvorrichtung auszuüben.

Die Verschlussstücke können bevorzugt als Klemmstücke für die Stellmuttern ausgebildet sein. Hierdurch lässt sich eine in eine gewünschte Drehposition eingestellte Stellmutter durch Klemmung arretieren, um ein nicht beabsichtigtes Verstellen zu verhindern.

Schließlich ist es vorteilhaft, wenn die Verschlussstücke Ringschrauben sind, die mit Außengewinden in Innengewinde der im Durchmesser größeren Bohrungsabschnitte eingeschraubt sind. Eine Drehung einer derartigen Ringschraube führt zu ihrer axialen Verlagerung, mit der Folge, dass die zugeordnete Stellmutter klemmend beaufschlagt und dadurch gesichert oder freigegeben wird.

Die Zeichnungen veranschaulichen die Erfindung anhand eines Ausführungsbeispiels und zwar zeigt:
- Figur 1: eine schematische Querschnittsansicht einer Prüfeinrichtung und
- Figur 2: eine vergrößerte Darstellung eines Bereichs der Prüfeinrichtung der Figur 1.

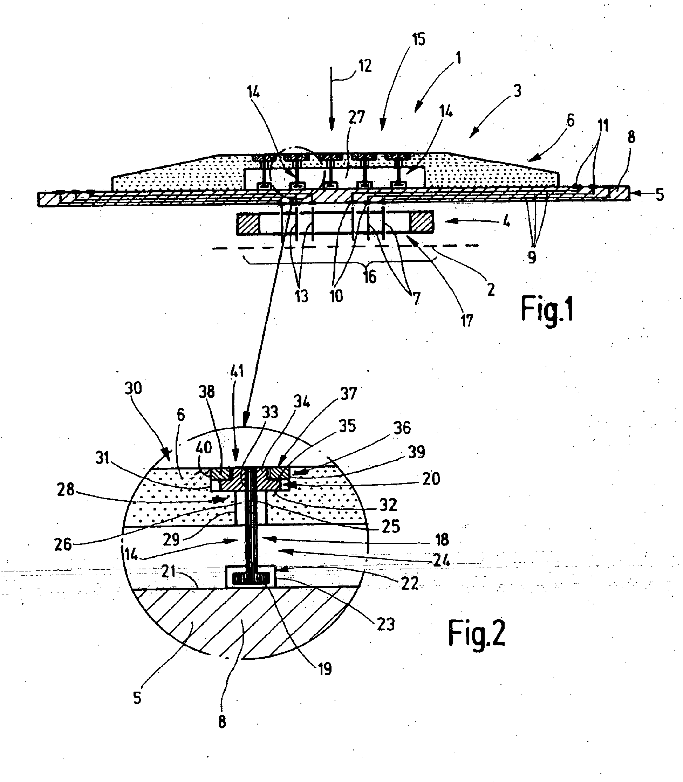

Die Figur 1 zeigt in schematischer Darstellung den Querschnitt durch eine elektrische Prüfeinrichtung 1, die zur Kontaktierung eines nicht dargestellten Prüflings mittels einer nicht dargestellten elektrischen Kabelverbindung an ein nicht dargestelltes Prüfsystem angeschlossen werden kann, um den Prüfling einer elektrischen Prüfung zu unterziehen. Der Prüfling, der als Wafer ausgebildet sein kann, befindet sich in der Prüfebene 2, die in Figur 1 als gestrichelte Linie dargestellt ist. Zur Kontaktierung entsprechender Anschlussstellen des Prüflings dient die erwähnte Prüfeinrichtung 1, die auch Vertikal-Prüfkante 3 genannt wird. Die Prüfeinrichtung 1 weist einen Kontaktkopf 4, eine Anschlussvorrichtung 5 und eine Abstützvorrichtung 6 auf. Die Anschlussvorrichtung 5 wird von der Abstützvorrichtung 6 abgestützt. Der Kontaktkopf 4 ist mit einer Vielzahl von längsverschieblich gelagerten Kontaktelementen 7 versehen, die mit ihren einen Endbereichen dem nicht dargestellten Prüfling und mit ihren anderen Endbereichen der Anschlussvorrichtung 5 zugeordnet sind. Die Anschlussvorrichtung 5 ist als mehrlagige Leiterplatte 8 mit Leiterbahnen 9 ausgebildet, wobei die Leiterbahnen 9 an ihren dem Kontaktkopf 4 zugeordneten Enden Kontaktflächen 10 und an ihren radial außen liegenden Enden elektrische Anschlussflächen 11 besitzen, wobei letztere über die erwähnten, nicht dargestellten Kabelverbindungen mit dem Prüfsystem verbindbar sind. Die Anordnung ist derart getroffen, dass die Anschlussvorrichtung 5 eine Umsetzvorrichtung bildet, d.h., der sehr enge Abstand der winzig kleinen Kontaktflächen 10 wird über die Leiterbahnen 9 in größere Abstände der Anschlussflächen 11 umgesetzt. Auch haben die Anschlussflächen 11 jeweils eine Größe, um die erwähnten Kabelverbindungen herstellen zu können.

Bei der Prüfung des Prüflings bewegt sich die Abstützvorrichtung 6 in axialer Richtung (Pfeil 12) auf den sich in der Prüfebene 2 befndlichen Prüfling zu, so dass die Stirnenden der Kontaktelemente 7 einerseits auf den Prüfling und andererseits auf die Kontaktflächen 10 auftreffen. Da die Kontaktelemente 7 als Knickdrähte 13 ausgebildet sind, also in axialer Richtung durch Durchbiegung leicht federnd ausgestaltet sind, ist eine einwandfreie Kontaktierung des Prüflings dann möglich, wenn die einzelnen Bauteile der Prüfeinrichtung 1 und auch der Prüfling jeweils eine hinreichende Planarität aufweisen. Probleme treten dann auf, wenn sich die der Anschlussvorrichtung 5 zugeordneten Stirnenden der Knickdrähte 13 alle in einer Ebene befinden, die zugeordneten Kontaktflächen 10 der Anschlussvorrichtung 5 jedoch aufgrund einer zum Beispiel konvexen Durchbiegung der Leiterplatte 8 keine planare Anordnung aufweisen. Um Einfluss auf die Planarität oder eine gewollte Nichtplanarität der Anschlussvorrichtung 5 nehmen zu können, sind zwischen Abstützvorrichtung 6 und Anschlussvorrichtung 5 die Zug- und Druckmittel 14 angeordnet. Es ist eine Vielzahl von Zug- und Druckmitteln 14 vorgesehen, die matrixartig im zentralen Bereich 15 der Prüfeinrichtung 1 angeordnet sind. Hierbei wird insbesondere der Grundflächenbereich 16 der Kontaktstiftanordnung 17 des Kontaktkopfs 4 mit Zug- und Druckmitteln 14 versehen. Die vergrößerte Darstellung der Figur 2 zeigt, dass jedes Zug- und Druckmittel 14 einen Gewindestift 18 mit Kopf 19 aufweist, wobei auf den Gewindestift 18 eine Stellmutter 20 aufgeschraubt ist. Auf der Oberseite 21 der Leiterplatte 8 sind Haltesockel 22 vorzugsweise durch Verkleben befestigt, die im Querschnitt C-Profilformen 23 aufweisen und die Köpfe 19 der Zug- und Druckmittel 14 aufnehmen. Erfolgt die Aufnahme des jeweiligen Kopfs 19 in der C-Profilform 23 mit einem gewissen Spiel, so stellt das Zug- und Druckmittel 14 ein Pendelzugmittel beziehungsweise Pendeldruckmittel 24 dar. Alternativ ist es jedoch auch möglich, den Kopf in die C-Profilform einzukleben, wobei ein Pendelausgleich durch Verbiegen des Zug- und Druckmittels 14 möglich ist. Der freie Endbereich 25 des jeweiligen Gewindestifts 18 ragt in eine Durchgangsöffnung 26 der Abstützvorrichtung 6. Zur Aufnahme der Haltesockel 22 und Abschnitte der Gewindestifte 18 ist die Abstützvorrichtung 6 auf ihrer der Anschlussvorrichtung 5 zugewandeten Seite mit einer Höhlung 27 (Figur 1) versehen. Die Figur 2 verdeutlicht, dass jede Durchgangsöffnung 26 als Stufenbohrung 28 ausgestaltet ist, d.h., sie weist einen im Durchmesser kleineren Bohrungsabschnitt 29 auf, der der Anschlussvorrichtung 5 zugeordnet ist und besitzt einen bis zur Außenseite 30 der Abstützvorrichtung 6 führenden, im Durchmesser größeren Bohrungsabschnitt 31. Hierdurch wird eine Ringstufe 32 ausgebildet.

Die Stellmutter 20 ist mit ihrem Innengewinde 33 auf das Ende 25 des Gewindestiftes 18 aufgeschraubt und besitzt einen zentralen, im Durchmesser kleineren Bereich 34 und damit einstückig einen im Durchmesser größeren äußeren Ringflansch 35. Der Ringflansch 35 stützt sich mit seiner Unterseite an der Ringstufe 32 ab.

Innerhalb des Bohrungsabschnitts 31 ist ein Verschlussstück 36 angeordnet, das klemmend auf den Ringflansch 35 der Stellmutter 20 aufliegen kann, so dass die Drehstellung der Stellmutter 20 zwischen der Ringstufe 32 und dem Verschlussstück 36 fixiert werden kann. Das Verschlussstück 36 bildet somit ein Klemmstück 37 und ist als Ringschraube 38 ausgebildet, die an ihrem Außendurchmesser ein Außengewinde 39 aufweist, das mit einem Innengewinde 40 des Bohrungsabschnitts 31 kämmt. Die Anordnung ist ferner derart getroffen, dass eine zentrale Öffnung 41 der Ringschraube 38 den im Durchmesser kleineren Bereich 34 der Stellmutter 20 aufnimmt.

Es ergibt sich folgende Funktion: Bei einer Kalibrierung der Prüfeinrichtung 1 wird diese auf einen sich in der Prüfebene 2 befindlichen Prüfling abgesenkt, so dass die Knickdrähte 13 einerseits Kontakt zum Prüfling und andererseits über die Kontaktflächen 10, Leiterbahnen 9 und Anschlussflächen 11 sowie die nicht dargestellten Kabelverbindungen elektrischen Kontakt mit dem nicht dargestellten Prüfsystem bekommen. Während des Absenkvorganges wird an einem Monitor des Prüfsystems dargestellt, in welchem Absenkzustand welche Kontaktelemente 7 Kontakt mit dem Prüfling erhalten. Ergibt sich beispielsweise, dass die in der Figur 1 rechtsseitig liegenden Kontaktelemente 7 vorzeitig und mit größerem Kontaktdruck auf den Prüfling aufliegen als die linksseitig liegenden Kontaktelemente 7, was durch einen entsprechenden Bildaufbau am Monitor des Prüfsystems deutlich wird, so lässt sich mittels der Zug- und Druckmittel 14 eine gewünschte Korrektur vornehmen. Diese kann darin bestehen, dass die rechtsseitig liegenden Zug- und Druckmittel 14 einen verstärkten Zug und/oder die linksseitig liegenden Zug- und Druckmittel 14 einen verstärkten Druck von der Abstützvorrichtung 6 auf die Leiterplatte 8 ausüben, so dass sich diese geringfügig elastisch verformt und demzufolge die Kontaktflächen 10 eine entsprechende axiale Höhenverlagerung erfahren.

Druckkräfte können dadurch aufgebracht werden, dass -bei Rechtsgewinde des Gewindestifts 18 und Lösen'der Ringschraube 38- die Stellmutter 20 durch Linksdrehung etwas weiter weg von ihrem Kopf 19 verlagert und dann durch Festziehen der Ringschraube 38 der Ringflansch 35 zwischen Ringschraube 38 und Ringstufe 32 eingeklemmt wird. Andererseits ist das Aufbringen einer Zugkraft dadurch möglich, dass -nach Lösen der Ringschraube 38- die Stellmutter 20 im Uhrzeigersinn (Rechtsdrehung) gedreht wird, wobei sie sich auf der Ringstufe 20 abstützt und demzufolge die Zugkraft über die C-Profilform 23 des Haltesockels 22 auf die Leiterplatte 8 überträgt. Anschließend wird die Ringschraube 38 wieder festgezogen, um den Ringflansch 35 der Stellmutter 20 zu ihrer Festlegung einzuklemmen. Auf diese Art und Weise kann an entsprechend vielen Stellen, nämlich je Zug- und Druckmittel 14, eine Einstellung der Planarität beziehungsweise Nichtplanarität der Anschlussvorrichtung 5 und somit der Anordnung ihrer Kontaktflächen 10 vorgenommen werden.

Aus der Figur 2 ist ersichtlich, dass der Bohrungsabschnitt 29 im Durchmesser größer als der Durchmesser des Gewindestiftes 18 ausgebildet ist, so dass auch hier eine gewisse Pendelauslenkung des Gewindestiftes 18 erfolgen kann, sofern es zu Temperaturausdehnungen der Bauteile kommt, die in einer Ebene liegen, die parallel zur Prüfebene 2 verläuft.

Um die erwähnten Drehverstellungen von Stellmutter 20 und/oder Ringschraube 38 vornehmen zu können, weisen diese beiden Bauelemente auf ihrer Oberseite einen Werkzeugeingriffsschlitz auf, so dass jeweils mit einem gabelförmigen Schraubendrehwerkzeug eine Verstellung problemlos möglich ist.

Mittels der Erfindung ist es möglich, die vertikale, also axiale Position der Anschlussvorrichtung 5, insbesondere der Leiterplatte 8, an verschiedenen Punkten zu justieren und zu fixieren, so dass eine optimale Kontaktierung des Prüflings möglich wird.

## Patentansprüche

1. Prüfeinrichtung (1) zur elektrischen Prüfung eines Prüflings, insbesondere zur Prüfung von Wafern, mit einem dem Prüfling zugeordneten Kontaktkopf (4) und mit einer elektrischen Anschlussvorrichtung (5), wobei der Kontaktkopf (4) mit stiftförmigen Kontaktelementen (7) versehen ist und die Kontaktelemente (7) eine Kontaktstiftanordnung bilden, und wobei die Anschlussvorrichtung (5) Kontaktflächen (10) aufweist, die mit Enden der Kontaktelemente (7) in Berührungskontakt stehen, wobei diese Enden der Kontaktelemente (7) einer Prüfebene (2) abgewandt liegen, welche den Prüfling aufnimmt, sowie mit einer auf einer Seite der Anschlussvorrichtung (5) angeordneten Abstützvorrichtung (6), wobei diese Seite der Anschlussvorrichtung (5) dem Kontaktkopf (4) abgewandt liegt, **dadurch gekennzeichnet, dass** zwischen Abstützvorrichtung (6) und Anschlussvorrichtung (5) Zugmittel und/oder Druckmittel (14) zur Einstellung der Planarität der Anordnung der Kontaktflächen (10) angeordnet sind, wobei durch Einstellung der Zugmittel und/oder Druckmittel (14) die Abstützvorrichtung (6) derart auf die Anschlussvorrichtung (5) wirkt, dass letztere sich elastisch verformt, sodass die verteilt angeordneten Kontaktflächen (10) in einer axialen Richtung der Prüfeinrichtung, vorzugsweise vertikal zur Prüfebene, verlagert werden, dass die Kontaktelemente (7) als Knickdrähte (13) und daher in axialer Richtung durch Durchbiegung leicht federnd ausgestaltet sind, und dass die Zugmittel und/oder Druckmittel (14) Temperaturausdehnungen der Anschlussvorrichtung (5) oder anderer Teile der Prüfeinrichtung (1) in einer Ebene zulassen, die parallel zur Prüfebene (2) verläuft, und zur Zulassung dieser Temperaturausdehnungen die Zugmittel und/oder Druckmittel (14) als in ihrer Längserstreckung mechanisch starre und quer zu dieser Längserstreckung eine Verlagerung durch Pendelung ermöglichende Pendelzugmittel und/oder Pendeldruckmittel (24) ausgebildet sind.

2. Prüfeinrichtung nach Anspruch 1, **dadurch gekennzeichnet, dass** mehrere Zugmittel und/oder Druckmittel (14) verteilt, bevorzugt matrixartig verteilt, im zentralen Bereich (15) der Prüfeinrichtung (1), insbesondere im Grundflächenbereich (16) der Kontaktstiftanordnung (17), vorgesehen sind.

3. Prüfeinrichtung nach einem der vorhergehenden Ansprüche, **dadurch gekennzeichnet, dass** die Zugmittel und/oder Druckmittel (14) Gewindestifte (18) aufweisen, die zur Aufbringung von Zugkräften und/oder Druckkräften mit Stellmuttern (20) zusammenwirken.

4. Prüfeinrichtung nach Anspruch 3, **dadurch gekennzeichnet, dass** die einen Enden der Gewindestifte (18) an der Anschlussvorrichtung (5) befestigt sind und dass sich die Stellmuttern (20) an der Abstützvorrichtung (6) abstützen.

5. Prüfeinrichtung nach Anspruch 4, **dadurch gekennzeichnet, dass** die der Anschlussvorrichtung (5) zugeordneten Enden der Gewindestifte (18) mit Köpfen (19) versehen sind, die von an der Anschlussvorrichtung (5) befestigten Haltesockeln (22) aufgenommen sind.

6. Prüfeinrichtung nach Anspruch 3, **dadurch gekennzeichnet, dass** die Gewindestifte (18) in Durchgangsöffnungen (26) der Abstützvorrichtung (6) einliegen oder diese Durchgangsöffnungen (26) durchragen.

7. Prüfeinrichtung nach Anspruch 3 und 6, **dadurch gekennzeichnet, dass** die Durchgangsöffnungen (26) als Stufenbohrungen (28) mit jeweils einem Bohrungsabschnitt (29) mit kleinerem und einem Bohrungsabschnitt (31) mit größerem Durchmesser ausgebildet sind, wobei in den Bohrungsabschnitten (31) mit größerem Durchmesser, die an einer Außenseite (30) der Abstützvorrichtung (6) liegen, die Stellmuttern (20) einliegen, die sich einerseits an den Stufen (32) der Stufenbohrungen (28) und andererseits an Verschlussstücken (36) in den im Durchmesser größeren Bohrungsabschnitten (31) abstützen.

8. Prüfeinrichtung nach Anspruch 7, **dadurch gekennzeichnet, dass** die Verschlussstücke (36) Klemmstücke (37) für die Stellmuttern (20) sind.

9. Prufeinrichtung nach Anspruch 7 und 8, **dadurch gekennzeichnet, dass** die Verschlussstücke (36) Ringschrauben (38) sind, die mit Außengewinden (39) in Innengewinde (40) der im Durchmesser größeren Bohrungsabschnitte (31) eingeschraubt sind.

## Claims

1. A test device (1) for electrical testing of a unit under test, in particular for testing wafers, with a contact head (4) associated with the unit under test, and with an electrical connecting apparatus (5), the contact head (4) being provided with pin-shaped contact elements (7) and the contact elements (7) forming a contact pin arrangement, the connecting apparatus (5) having contact surfaces (10) being in touch-contact with ends of the contact elements (7), said ends of the contact elements (7) facing away from a test plane (2) accommodating the unit under test, and with a supporting apparatus (6) arranged on a side of the connecting apparatus (5), said side of the connecting apparatus (5) facing away from the contact head (4), **characterized in that** pulling means and/or pushing means (14) for adjusting the planar condition of the arrangement of the contact surfaces (10) are arranged between the supporting apparatus (6) and the connecting apparatus (5), the supporting apparatus (6) acting on the connecting apparatus (5) by adjusting the pulling and/or pushing means (14) such that the connecting apparatus (5) elastically deforms so that the distributed contact surfaces (10) are displaced in an axial direction of the test device, preferably perpendicular to the test plane, that the contact elements (7) are in the form of bend wires (13) and, thus, are configured slightly resilient by bending in axial direction, and that the pulling means and/or pushing means (14) allow thermal expansions of the connecting apparatus (5) or of other parts of the test device (1) in a plane which runs parallel to the test plane (2), and, for allowing said thermal expansions, the pulling means and/or pushing means (14) are configured as pendular pulling means and/or pendular pushing means (24) which are mechanically rigid in their longitudinal extension and which permit a displacement by pendular movement transversely to said longitudinal extension.

2. Test device according to claim 1, **characterized in that** several pulling means and/or pushing means (14) are provided distributed, prefereably distributed like a matrix, in the central area (15) of the test device (1), in particular in the base surface area (16) of the contact pin arrangement (17).

3. Test device according to any one of the preceding claims, **characterized in that** the pulling means and/or pushing means (14) comprise threaded pins (18) which interact with adjusting nuts (20) to apply pulling forces and or pushing forces.

4. Test device according to claim 3, **characterized in that** the one ends of the threaded pins (18) are attached to the connecting apparatus (5), and that the adjusting nuts (20) are supported on the supporting apparatus (6).

5. Test device according to claim 4, **characterized in that** the ends of the threaded pins (18) associated with the connecting apparatus (5) are provided with heads (19) which are held by holding caps (22) that are attached to the connecting apparatus (5).

6. Test device according to claim 3, **characterized in that** the threaded pins (18) are located in through-holes (26) of the supporting apparatus (6) or protrude through said through-holes (26).

7. Test device according to claim 3 and 6, **characterized in that** the through-holes (26) are configured as stepped boreholes (28), each hole having a borehole section (29) with a smaller diameter and a borehole section (31) with a larger diameter, the adjusting nuts (20) are located in the borehole sections (31) with the larger diameter located on an outside (30) of the supporting apparatus (6), the adjusting nuts being supported on the steps (32) of the stepped boreholes (28) on the one hand and, on the other hand, on closure pieces (36) in the borehole sections (31) having the larger diameter.

8. Test device according to claim 7, **characterized in that** the closure pieces (36) are clamping pieces (37) for the adjusting nuts (20).

9. Test device according to claim 7 and 8, **characterized in that** the closure pieces (36) are eyebolts (38) having external threads (39) that are screwed into internal threads (40) of the borehole sections (31) having the larger diameter.

## Revendications

1. Dispositif d'essai (1) pour l'essai électronique d'une éprouvette, en particulier pour l'essai de tranches, comprenant une tête de contact (4) attribuée à l'éprouvette et comprenant un dispositif de connexion électrique (5), sachant que la tête de contact (4) est dotée d'éléments de contact (7) en forme de broche et les éléments de contact (7) forment un agencement de broches de contact, et sachant que le dispositif de connexion (5) présente des surfaces de contact (10) qui sont en contact tactile avec les extrémités des éléments de contact (7), sachant que ces extrémités des éléments de contact (7) sont placées en étant détournées d'un plan d'essai (2), laquelle reçoit l'éprouvette, ainsi qu'un dispositif d'appui (6) disposé sur un côté du dispositif de connexion (5), sachant que ce côté du dispositif de connexion (5) est placé détourné de la tête de contact (4), **caractérisé en ce que** des moyens de traction et/ou de pression (14) sont prévus entre le dispositif d'appui (6) et le dispositif de connexion (5) pour régler la planéité de l'agencement des surfaces de contact (10), sachant que le réglage des moyens de traction et/ou de pression (14) fait en sorte que le dispositif d'appui (6) agit de telle façon sur le dispositif de connexion (5) que ce dernier se déforme de façon élastique, de sorte que les surfaces de contact (10) disposées réparties sont décalées dans un sens axial du dispositif d'essai, de préférence verticalement au plan d'essai, que les éléments de contact (7) sont conçus en tant que fils coudés (13) et donc légèrement élastiques par flexion dans le sens axial, et que les moyens de traction et/ou de pression (14) autorisent des dilatations de température du dispositif de connexion (5) ou d'autres parties du dispositif d'essai (1) dans un plan qui est parallèle au plan d'essai (2), et que pour autoriser ces dilatations de température, les moyens de traction et/ou de pression (14) sont conçus en tant que moyens de traction et/ou de pression à oscillation (24) fixes mécaniquement dans leur extension longitudinale et permettant un déplacement par oscillation transversalement à cette extension longitudinale.

2. Dispositif d'essai selon la revendication 1, **caractérisé en ce que** plusieurs moyens de traction et/ou de pression (14) répartis sont prévus, répartis de préférence en matrice, dans la partie centrale (15) du dispositif d'essai (1), en particulier dans la région de la surface de base (16) de l'agencement de broches de contact (17).

3. Dispositif d'essai selon l'une des revendications précédentes, **caractérisé en ce que** les moyens de traction et/ou de pression (14) présentent des tiges filetées (18) qui coopèrent avec des écrous de réglage (20) pour appliquer des forces de traction et/ou de pression.

4. Dispositif d'essai selon la revendication 3, **caractérisé en ce que** les unes extrémités des tiges filetées (18) sont fixées sur le dispositif de connexion (5) et que les écrous de réglage (20) s'appuient sur le dispositif d'appui (6).

5. Dispositif d'essai selon la revendication 4, **caractérisé en ce que** les extrémités des tiges filetées (18) correspondant au dispositif de connexion (5) sont dotées de têtes (19) qui sont reçues par des socles de fixation (22) fixés sur le dispositif de connexion (5).

6. Dispositif d'essai selon la revendication 3, **caractérisé en ce que** les tiges filetées (18) sont insérées dans des ouvertures de passage (26) du dispositif d'appui (6) ou traversent ces ouvertures de passage (26).

7. Dispositif d'essai selon la revendication 3 et 6, **caractérisé en ce que** les ouvertures de passage (26) sont conçues en tant qu'alésages étagés (28) avec respectivement un tronçon d'alésage (29) avec un plus petit diamètre et un tronçon d'alésage (31) avec un plus grand diamètre, sachant que les écrous de réglage (20), lesquels s'appuient d'une part sur les étages (32) des alésages étagés (28) et sur des pièces de raccord (36) dans les tronçons d'alésage à plus grand diamètre (31) d'autre part, sont insérés dans les tronçons d'alésage à plus grand diamètre (31) qui reposent sur un côté extérieur (30) du dispositif d'appui (6).

8. Dispositif d'essai selon la revendication 7, **caractérisé en ce que** les pièces de raccord (36) sont des éléments de serrage (37) pour les écrous de réglage (20).

9. Dispositif d'essai selon la revendication 7 et 8, **caractérisé en ce que** les pièces de raccord (36) sont des vis à anneau (38) qui sont vissées par des filetages mâles (39) dans des filetages femelles (40) des tronçons d'alésage (31) à plus grand diamètre.
